# EUROPÄISCHE PATENTSCHRIFT

(11) **EP 4 105 811 B1**
(45) Veröffentlichungstag und Bekanntmachung des Hinweises auf die Patenterteilung: **23.07.2025**
(21) Anmeldenummer: 22163416.5
(22) Anmeldetag: 22.03.2022
(51) Int. Cl.: G06F 30/15, G06F 11/3668, G06F 8/36, G06F 30/20

(54) **COMPUTERIMPLEMENTIERTES VERFAHREN ZUM SZENARIOBASIERTEN TESTEN UND/ODER HOMOLOGATION VON ZU TESTENDEN ZUMINDEST TEILWEISE AUTONOMEN FAHRFUNKTIONEN DURCH KEY PERFORMANCE INDICATORS (KPI)**
COMPUTER-IMPLEMENTED METHOD FOR SCENARIO-BASED TESTING AND / OR HOMOLOGATION OF AT LEAST PARTIALLY AUTONOMOUS TRAVEL FUNCTIONS TO BE TESTED BY KEY PERFORMANCE INDICATORS (KPI)
PROCÉDÉ MIS EN UVRE PAR ORDINATEUR DESTINÉ À L'ESSAI ET/OU À L'HOMOLOGATION BASÉ SUR DES SCÉNARIOS DES FONCTIONS DE CONDUITE AU MOINS PARTIELLEMENT AUTONOMES À METTRE À L'ESSAI AU MOYEN DES INDICATEURS CLÉS DE PERFORMANCE (ICP)

(30) Priorität: 04.05.2021 DE 102021111462
(43) Veröffentlichungstag der Anmeldung: 21.12.2022
(73) Patentinhaber: dSPACE GmbH, 33102 Paderborn (DE)
(72) Erfinder: Bannenberg, Sebastian, 33102 Paderborn (DE); Beringer, Steffen, 33102 Paderborn (DE); Miller, Eduard, 33102 Paderborn (DE); Deppe, Markus, 33102 Paderborn (DE)

(56) Entgegenhaltungen:
- CHRISTIAN BERGER: "Automating acceptance tests for sensor- and actuator-based systems on the example of autonomous vehicles", AACHENER INFORMATIK-BERICHTE, SOFTWARE ENGINEERING, 1 August 2010 (2010-08-01), Aachen, XP055468045, ISBN: 978-3-8322-9378-9, Retrieved from the Internet <URL:http://www.se-rwth.de/phdtheses/Diss-Berger-Automating-Acceptance-Tests-for-Sensor-and-Actuator-based-Systems-on-the-Example-of-Autonomous-Vehicles.pdf> [retrieved on 20180417]

## Beschreibung

Die vorliegende Erfindung betrifft ein computerimplementiertes Verfahren zum Szenario-basierten Testen und/oder Homologation von zu testenden zumindest teilweise autonomen Fahrfunktionen durch Key Performance Indicators (KPI).

Die vorliegende Erfindung betrifft des Weiteren eine Testeinheit zum Szenario-basierten Testen und/oder Homologation von zu testenden zumindest teilweise autonomen Fahrfunktionen durch Key Performance Indicators (KPI). Die vorliegende Erfindung betrifft darüber hinaus ein Computerprogramm und einen computerlesbaren Datenträger.

### Stand der Technik

Fahrassistenzsysteme wie z.B. ein adaptiver Geschwindigkeitsregler und/oder Funktionen für das hochautomatisierte bzw. autonome Fahren können mithilfe diverser Überprüfungsmethoden verifiziert bzw. validiert werden. Dabei können insbesondere Hardware-in-the-Loop Verfahren, Software-in-the-Loop Verfahren, Simulationen und/oder Testfahrten verwendet werden.

Der Aufwand, insbesondere der Zeit- und/oder Kostenaufwand, zum Testen derartiger Fahrzeugfunktionen unter Verwendung der oben genannten Überprüfungsmethoden ist dabei typischerweise sehr hoch, da eine große Anzahl potenziell möglicher Fahrsituationen getestet werden muss.

Ein zumindest teilweise autonomes Verkehrsmittel ausschließlich auf der Straße mit Fahrtstrecken über Milliarden Kilometer zu testen ist aus Zeit- und Kostengründen nicht möglich. Zudem würden viele redundante Testkilometer entstehen, während kritische und ungewöhnliche Situationen, die aber relevant für die Fähigkeiten des zumindest teilweise autonomen Fahrzeugs sind, nicht auftreten.

Dies kann insbesondere zu einem hohen Aufwand für Testfahrten als auch für Simulationen führen. DE 10 2017 200 180 A1 gibt ein Verfahren zur Verifizierung und/oder Validierung einer Fahrzeugfunktion an, welche dafür vorgesehen ist, ein Fahrzeug in Längs- und/oder Querrichtung autonom zu führen.

Das Verfahren umfasst ein Ermitteln, auf Basis von Umfelddaten bezüglich eines Umfelds des Fahrzeugs, einer Test-Steueranweisung der Fahrzeugfunktion an einen Aktuator des Fahrzeugs, wobei die Test-Steueranweisung nicht durch den Aktuator umgesetzt wird.

Das Verfahren umfasst des Weiteren ein Simulieren, auf Basis von Umfelddaten und unter Verwendung eines Verkehrsteilnehmer-Modells bezüglich zumindest eines Verkehrsteilnehmers im Umfeld des Fahrzeugs, einer fiktiven Verkehrssituation, die vorliegen würde, wenn die Test-Steueranweisung umgesetzt worden wäre.

Das Verfahren umfasst ferner ein Bereitstellen von Testdaten in Bezug auf die fiktive Verkehrssituation. Die Fahrzeugfunktion wird hierbei zum Ermitteln der Test-Steueranweisung passiv im Fahrzeug betrieben.

Nachteilhaft an diesem Verfahren ist, dass zur Verifizierung und/oder Validierung der Fahrzeugfunktion ein tatsächlicher Betrieb des Fahrzeugs zum Ermitteln der benötigten Daten erforderlich ist.

Christian Berger: Automating acceptance tests for sensor- and actuatorbased systems on the example of autonomous vehicles offenbart ein Verfahren zum Automatisieren von Abnahmetests am Beispiel eines autonomen Fahrzeugs.

Die vorgestellte konzeptionelle Theorie besteht darin, aus den Anforderungen und Akzeptanzkriterien eine formale, maschinenverarbeitbare Spezifikation des Systemkontextes eines in der Entwicklung befindlichen Systems abzuleiten, um interaktive sowie unbeaufsichtigte und automatisierbare Simulationen für das in der Entwicklung befindlichen Systems zu generieren und durchzuführen.

Die Hersteller von zumindest teilweise autonomen Verkehrsmitteln benötigen eine parallelisierte, simulationsbasierte Lösung. Die Testmethode "Szenariobasiertes Testen" setzt hier an. Dazu ist eine intelligente Testnachsteuerung erforderlich, die eine Bewertung von Simulationsergebnissen vornimmt und gegebenenfalls eine veränderte Parametrierung vornimmt.

Es ist daher Aufgabe der Erfindung, ein Verfahren, eine Testeinheit, ein Computerprogramm und einen computerlesbaren Datenträger anzugeben, welches eine Bewertung von Simulationen und / oder Testfällen im Szenario-basierten Testen und / oder Homologation von zu testenden zumindest teilweise autonomen Fahrfunktionen durch Key Performance Indicators (KPI) angibt. Das erfindungsgemäße Verfahren umfasst ein Abbilden von KPIs durch KPI-Plug-ins;
dynamisches und wiederverwendbares Wählen von KPI-Plug-Ins für Simulationen und / oder Testfälle;
Wählen zumindest eines KPI-Plug-Ins durch einen KPI-Plug-In-Mechanismus bei der Simulations- und / oder Testdefinition;
automatisches Ausführen des gewählten KPI-Plug-Ins durch den KPI-Plug-In-Mechanismus während der Ausführung des KPI-Plug-In-Mechanismus;
Bestimmen eines KPI-Wertes durch Übergabe eines Simulationsergebnisses an ein KPI-Skript des KPI-Plug-Ins;
Übermitteln des Simulationsergebnisses und des KPI-Werts an eine Testerstellung und Konfiguration und Erzeugen optimierter Testfälle und / oder einer optimierten Parameterkonfiguration; und
Bereitstellen einer unter Verwendung der optimierten Testfälle und / oder der optimierten Parameterkonfiguration optimierten zumindest teilweise autonomen Fahrfunktion.

Ferner umfasst die Testeinheit zur Bewertung von Simulationen und / oder Testfällen im Szenario-basierten Testen und / oder Homologation von zu testenden zumindest teilweise autonomen Fahrfunktionen durch Key Performance Indicators (KPI) Mittel zum Abbilden von KPIs durch KPI-Plug-ins; dynamisches und wiederverwendbares Wählen von KPI-Plug-Ins für Simulationen und / oder Testfälle; Mittel zum Wählen zumindest eines KPI-Plug-Ins durch einen KPI-Plug-In-Mechanismus bei der Simulations- und / oder Testdefinition; Mittel zum automatischen Ausführen des gewählten KPI-Plug-Ins durch den KPI-Plug-In-Mechanismus während der Ausführung des KPI-Plug-In-Mechanismus; Mittel zum Bestimmen eines KPI-Wertes durch Übergabe eines Simulationsergebnisses an ein KPI-Skript des KPI-Plug-Ins; Mittel zum Übermitteln des Simulationsergebnisses und des KPI-Werts an eine Testerstellung und Konfiguration und Erzeugen optimierter Testfälle und / oder einer optimierten Parameterkonfiguration; und Mittel zum Bereitstellen einer unter Verwendung der optimierten Testfälle und / oder der optimierten Parameterkonfiguration optimierten zumindest teilweise autonomen Fahrfunktion.

### Offenbarung der Erfindung

Die Aufgabe wird erfindungsgemäß gelöst durch ein computerimplementiertes Verfahren zur Bewertung von Simulationen und / oder Testfällen im Szenario-basierten Testen und / oder Homologation von zu testenden zumindest teilweise autonomen Fahrfunktionen durch Key Performance Indicators (KPI) nach Patentanspruch 1, eine Testeinheit nach Patentanspruch 12, ein Computerprogramm nach Patentanspruch 14 und einen computerlesbaren Datenträger nach Patentanspruch 15.

Ein autonomes Fahrzeug enthält eine Vielzahl von Steuergeräten. Jedes einzelne Steuergerät und deren Verbund müssen bei der Entwicklung und bei der Homologation ausgiebig getestet werden. Um die fehlerfreie Funktionsweise der Steuergeräte in jeder Verkehrssituation sicherzustellen, wird Szenario-basiert getestet. Beim Szenario-basierten Testen wird die Fahrweise des Fahrzeugs in einer möglichst realitätsnahen Verkehrssituation analysiert. Die zu analysierenden Aspekte der Verkehrssituation und deren Bewertung sind abhängig von dem zu testenden System. Dazu werden beim Szenario-basierten Testen von Systemen und Systemkomponenten zur autonomen Führung eines Kraftfahrzeugs Szenarien definiert, welche als Abstraktion einer Verkehrssituation bezeichnet werden können. Für jedes Szenario können dann wiederum Testfälle ausgeführt werden. Ein logisches Szenario ist hierbei die Abstraktion einer Verkehrssituation mit der Straße, dem Fahrverhalten und dem umliegenden Verkehr ohne konkrete Parameterwerte festzulegen. Durch die Wahl konkreter Parameterwerte wird aus dem logischen Szenario ein konkretes Szenario. Ein solches konkretes Szenario entspricht einer jeweils einzelnen Verkehrssituation.

Zur grundsätzlichen erfindungsgemäßen Unterscheidung der Verkehrsszenarien bzw. Szenarien im Szenario-basierten-Testen werden nicht nur statische Parameter, wie z.B. aber nicht ausschließlich Umfeld, Bebauung oder Fahrbahnbreite herangezogen, sondern insbesondere auch das Fahrverhalten der einzelnen Verkehrsteilnehmer. Die Bewegungen der Verkehrsteilnehmer und damit das Fahrverhalten werden durch Trajektorien beschrieben. Trajektorien beschreiben einen Pfad sowohl in räumlicher als auch in zeitlicher Richtung. Durch Parameter wie z.B. Geschwindigkeit, können Bewegungen von Verkehrsteilnehmer unterschieden werden.

Eine autonome Fahrfunktion ist durch ein System, beispielsweise ein Steuergerät, realisiert. Das Steuergerät wird herkömmlicherweise im realen Fahrzeug in realen Verkehrssituationen getestet, durch Hardware-in-the-Ioop Tests oder alternativ durch vollständig virtuelle Tests validiert.

Dazu kann auch eine Simulation genutzt werden.

Unter Verwendung des vorliegenden Verfahrens kann beispielsweise ein sogenanntes Cut-In-Szenario von anderen Szenarien unterschieden werden. Das Cut-In-Szenario kann als Verkehrssituation bezeichnet werden, bei welcher ein hochautomatisiertes bzw. autonomes Fahrzeug in einer vorgegebenen Fahrspur fährt und ein anderes Fahrzeug mit gegenüber dem Ego-Fahrzeug verringerter Geschwindigkeit von einer weiteren Fahrspur in die Fahrspur des Ego-Fahrzeugs in einem bestimmten Abstand einschert. Das Ego-Fahrzeug bezeichnet hier das zu testende Fahrzeug (SUT).

Die Geschwindigkeiten des Ego-Fahrzeugs und des weiteren Fahrzeugs, welches auch als Fellow-Fahrzeug bezeichnet wird, sind dabei konstant. Da die Geschwindigkeit des Ego-Fahrzeugs höher ist als die des Fellows, muss das Ego-Fahrzeug abgebremst werden, um eine Kollision der beiden Fahrzeuge zu vermeiden.

Aber auch ein Cut-in-Szenario kann in verschiedenen Ausprägungsformen vorliegen, wie z.B. durch eine Unterscheidung in der Geschwindigkeit der Verkehrsteilnehmer.

Des Weiteren ist ein Szenario, wie ein Passing-By-Scenario, möglich, indem das Ego-Fahrzeug das überholende Fahrzeug darstellt, so dass das Ego-Fahrzeug in einer vorgegebenen Fahrspur fährt und ein anderes Fahrzeug mit gegenüber dem Ego-Fahrzeug verringerter Geschwindigkeit überholt. Dabei wechselt/schert das Ego-Fahrzeugt auf eine weitere Fahrspur aus und fährt mit höherer Geschwindigkeit an dem Fellow-Fahrzeug vorbei. Die Geschwindigkeit des Ego-Fahrzeug muss in diesem Szenario nicht konstant sein. Nachdem das Ego-Fahrzeug an dem Fellow-Fahrzeug vorbeigefahren ist, schert das Ego-Fahrzeug wieder auf die vorherige Fahrspur ein.

Solche Szenarien können mit unterschiedlichen Parameterwerten simuliert werden. Um möglichst ressourcenschonend Simulations- und Rechenzeit einzusetzen, ist eine Testnachsteuerung erforderlich, um eine hohe Abdeckung - Homologation, zu erreichen. Dazu muss eine angemessene Bewertung von Simulationsergebnissen, aber gegebenenfalls auch von jedem Simulationsschritt erfolgen.

Der Begriff Key-Performance-Indicator (KPI) bezeichnet im erfindungsgemäßen Verfahren KPI-Werte, anhand derer der Fortschritt oder der Erfüllungsgrad hinsichtlich wichtiger Zielsetzungen oder kritischer Erfolgsfaktoren nach oder während einer Simulation von zumindest teilweise autonomen Fahrzeugen gemessen und / oder ermittelt werden kann. KPIs und / oder KPI-Werte erlauben eine Bewertung der Simulation und / oder des Simulationsschritts zur Testnachsteuerung, so dass gezielter, ressourcenschonender und zeiteffizienter getestet werden kann.

Dazu werden erfindungsgemäß KPIs als KPI-Plug-Ins umgesetzt. Ein KPI-Plug-In umfasst ein ausführbares Skript bzw. ein KPI-Skript und eine Konfigurationsbeschreibung. In dem ausführbaren Skript wird die Ermittlungsweise des KPI-Wertes festgehalten und in der Konfigurationsbeschreibung zumindest angegeben, welche Eingabedaten das Skript benötigt, wie es ausgeführt werden muss, und ggf. zusätzliche Metadaten, die beschreiben, in welchen Szenarien das KPI-Plug-In anwendbar ist. Metadaten, die die Anwendbarkeit des KPI-Plug-Ins in einem Szenario anzeigen, können z.B. eine Bedingung für Szenerie-Parameter, wie eine spezifische Fahrbahnbreite, oder Fahrsituationsparameter, wie die Anzahl an Verkehrsteilnehmern oder Geschwindigkeitsrestriktionen, sein. Damit ist ein KPI-Plug-In in verschiedenen Szenarien und / oder Tests wiederverwendbar. Es ist dazu nicht notwendig das auszuführende Skript und / oder die Konfigurationsdatei für die Verwendung in unterschiedlichen Szenarien anzupassen. Damit ist ein KPI-Plug-In dynamisch bei der Test- wie Simulationserstellung und / oder bei der Simulationsausführung auswählbar und in Tests und / oder Simulationen integrierbar und können damit in verschiedenen Simulationen und / oder Tests in unterschiedlichen Szenarien eingesetzt werden. Die Auswahl kann erfindungsgemäß vor und / oder nach der Test- und / oder Simulationserstellung erfolgen. Die Auswahl eines Plug-Ins kann je nach Ausführungsform der Erfindung variieren. In einer bevorzugten Ausführungsform ist eine Auswahl des KPI-Plug-Ins in einer Benutzungsschnittstelle durch einen Test- / Simulationsersteller möglich. In weiteren Ausführungsformen ist auch eine programmierbare Einbindung des KPI-Plug-In möglich. Weitere Ausführungsformen sollen mit dem erfindungsgemäßen computerimplementierten Verfahren umfasst werden. Durch das erfindungsgemäße computerimplementierte Verfahren werden Ausführungszeiten einer Simulation inklusive Simulationserstellung verkürzt.

Weitere Aufgabe der Erfindung ist es die Ausführung des zumindest einen gewählten KPI-Plug-In automatisiert durchzuführen. Dazu ist ein KPI-Plug-In-Mechanismus eingerichtet. Mit der Testdefinition und / oder Simulationserstellung bekommt der KPI-Plug-In Mechanismus das KPI-Plug-In. Anschließend hält der KPI-Plug-In Mechanismus das KPI-Plug-In und führt diesen an der vorgesehenen Stelle aus. Die Ausführung des KPI-Plug-In liefert den KPI-Wert, den der KPI-Plug-In Mechanismus nach der Ausführung zu den Test- und / oder Simulationsergebnissen abspeichert.

Der KPI-Plug-In-Mechanismus ist dazu vorgesehen KPI-Plug-Ins in zwei verschiedenen Varianten auszuführen. Die Ausführungsvariante ist in der Konfigurationsdatei festgelegt.

Eine erste Ausführungsvariante findet online und damit gleichzeitig zur Simulation statt. In diesem Fall findet eine Bewertung in jedem Simulationsschritt statt und der KPI-Wert steht direkt nach der Simulation zur Verfügung. Die Bewertung erfolgt auf den während der Ausführung zur Verfügung stehenden Simulationsparameter, wie Szenerie-Parametern und / oder Fahrsituationsparametern.

Die zweite Ausführungsvariante ist der aktuellen Simulation nachgelagert, also offline. Es werden damit nicht echtzeitfähig Parameter während der Simulation betrachtet und zur Ermittlung des KPI-Werts genutzt, sondern der KPI-Wert wird erst nach der Simulation bestimmt. Es werden zur Bestimmung des KPI-Werts Simulationsergebnisse an das KPI-Skript übergeben. Grundsätzlich kann der KPI-Plug-In-Mechanismus zumindest ein KPI-Plug-In, aber auch mehrere KPI-Plug-Ins halten. Alle am KPI-Plug-In-Mechanismus registrierten KPI-Plug-Ins für eine Testausführung und / oder Simulation werden ausgeführt.

Zur besseren Wiederverwendbarkeit werden alle KPI-Plug-Ins in einem KPI-Plug-In Pool verwaltet.

Im Gegensatz zu den bereits bekannten Methoden, eine Bewertung in das Szenario-basierte Testen zu integrieren, managet der KPI-Plug-In Mechanismus die KPI-Plug-Ins und deren Ausführung. Dadurch sind die KPI-Plug-Ins nicht fest mit der Simulation verknüpft und müssen nicht pro Szenario oder SUT neu definiert werden. Bei bereits bekannten Methoden ist die Verknüpfung von Bewertung und Szenario notwendig. Neben der Wiederverwendbarkeit sticht im erfindungsgemäßen Verfahren die automatische Ausführung der KPI-Plug-Ins heraus. Zur Laufzeit ladet, prüft und führt der KPI-Plug-In-Mechanismus die ausgewählten KPI-Plug-Ins automatisiert aus.

Der KPI-Plug-In Mechanismus benötigt eine standardisierte KPI-Konfiguration und standardisierte Schnittstellen für KPI-Skripte. Die vorgegebenen Standards ermöglichen, dass die KPI-Entwicklung getrennt von der Szenarien-Entwicklung behandelt werden kann.

Weitere Ausführungsformen der vorliegenden Erfindung sind Gegenstand der weiteren Unteransprüche und der nachfolgenden Beschreibung unter Bezugnahme auf die Figuren.

Die Testeinheit umfasst Mittel zur Bewertung von Simulationen und / oder Testfällen im Szenario-basierten Testen und / oder Homologation von zu testenden zumindest teilweise autonomen Fahrfunktionen durch Key Performance Indicators (KPI).

Gemäß einem weiteren Aspekt der Erfindung ist ferner ein Computerprogramm mit Programmcode vorgesehen, um das erfindungsgemäße Verfahren durchzuführen, wenn das Computerprogramm auf einem Computer ausgeführt wird. Gemäß einem weiteren Aspekt der Erfindung ist ein Datenträger mit Programmcode eines Computerprogramms vorgesehen, um das erfindungsgemäße Verfahren durchzuführen, wenn das Computerprogramm auf einem Computer ausgeführt wird.

Die hierin beschriebenen Merkmale des computerimplementierten Verfahrens sind zur Bewertung von Simulationen und / oder Testfällen im Szenario-basierten Testen und / oder Homologation von zu testenden zumindest teilweise autonomen Fahrfunktionen durch Key Performance Indicators (KPI) verwendbar. Ebenfalls ist die erfindungsgemäße Testeinheit dazu geeignet, eine Testnachsteuerung von einer Vielzahl unterschiedlicher Vorrichtungen bzw. Steuergeräte von z.B. Automobilen, Nutzfahrzeugen und / oder kommerziellen Fahrzeugen, Schiffen oder Flugzeugen durchzuführen durch eine Bewertung von Simulationsergebnissen und / oder Simulationsschritten unterschiedlicher Szenarien bzw. Fahrsituationen.

### Kurze Beschreibung der Zeichnungen

Zum besseren Verständnis der vorliegenden Erfindung und ihrer Vorteile wird nun auf die nachfolgende Beschreibung in Verbindung mit den zugehörigen Zeichnungen verwiesen. Nachfolgend wird die Erfindung anhand exemplarischer Ausführungsformen näher erläutert, die in den schematischen Abbildungen der Zeichnungen angegeben sind.

Es zeigen:
- Figur 1: zeigt eine schematische Darstellung zur erfindungsgemäßen Unterscheidung von Szenarios,
- Figur 2: zeigt eine schematische Ansicht, die eine Grenze zwischen kritischen und nicht-kritischen Testergebnissen angibt,
- Figur 3: zeigt eine erfindungsgemäße Darstellung eines KPI-Plug-Ins
- Figur 4: zeigt eine schematische Darstellung zur erfindungsgemäßen Beschreibung des KPI-Plug-In-Mechanismus und des KPI-Plug-In Pools
- Figur 5: zeigt eine schematische Darstellung zur erfindungsgemäßen Beschreibung der Verwendung von KPI-Plug-Ins
- Figur 6: zeigt eine schematische Darstellung zur erfindungsgemäßen Beschreibung der Verwendung von KPI-Plug-Ins
- Figur 7: zeigt eine schematische Darstellung zur erfindungsgemäßen Bestimmung eines KPI-Werts
- Figur 8: zeigt den Ablauf des erfindungsgemäßen offline-Einsatz des KPI-Plug-In-Mechanismus
- Figur 9: zeigt den Ablauf des erfindungsgemäßen online-Einsatz des KPI-Plug-In-Mechanismus

### Ausführliche Beschreibung der Ausführungsformen

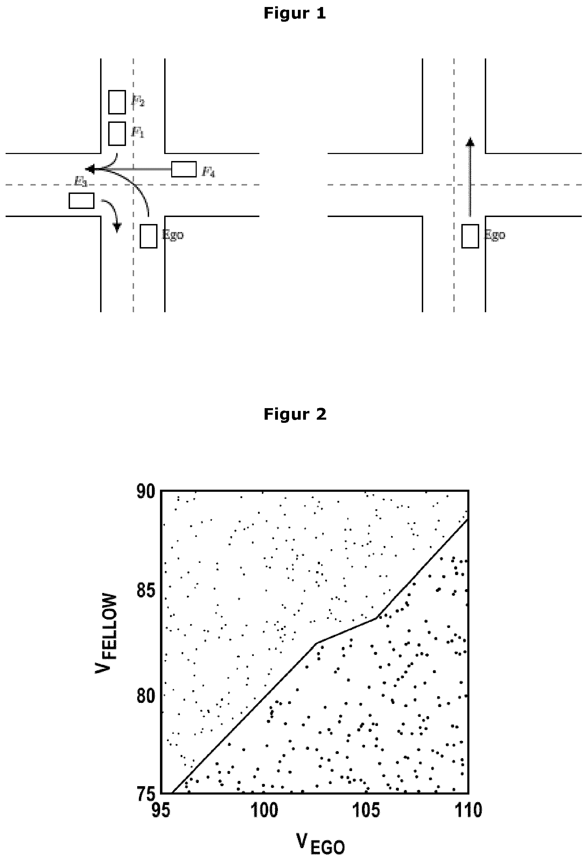

Figur 1 beschreibt zwei verschiedene Szenarien S1 und S2. Es wird jeweils ein Kreuzungsbereich dargestellt. In beiden Szenarien S1 und S2 ist ein Ego-Fahrzeug (Ego) dargestellt. In S1 führt das Ego-Fahrzeug (Ego) ein Abbiegemanöver durch. Das Egofahrzeug ist auch das "Subject under Test" (SUT). Es sind dabei vier Fellowfahrzeuge (F1 bis F4) beteiligt. In S2 folgt das Ego-Fahrzeug dem Fahrverlauf geradeaus ohne Beteiligung von Fellowfahrzeugen. Es liegen demnach Unterschiede in den Szenerie-Parametern wie auch Fahrsituationsparameter vor. Ziel in den Szenarien kann z.B. die Testung und Simulation eines Abstandsregeltempomat sein. Bei der Testdefinition bekommt der KPI-Plug-In Mechanismus das KPI-Plug-In zur Bewertung des Abstandsregeltempomat, bestehend aus dem Skript und der Konfigurationsbeschreibung. Während und / oder nach der Simulation wird das definierte KPI-Skript ausgeführt und der resultierende KPI-Wert wird abgespeichert. Es ist möglich für beide Szenarien ein gleichbleibendes KPI-Plug-In zu verwenden.

In einer weiteren Ausführung kann ein Abstandsregeltempomat in ein Egofahrzeug (Ego) in Szenarien auf der Autobahn und / oder der Innenstadt getestet werden. Dabei kann insbesondere ein Einschervorgang (Cut-In-Szenario) von Interesse sein. Hierbei unterscheiden sich die Szenarien dann auch insbesondere in den Szenerie-Parameter.

Zunächst wird bei der Testkonfiguration das Autobahnszenario ausgewählt. Bei dem Szenario ist für das Egofahrzeug (Ego) relevant, ob eine Kollision aufgetreten ist. Zusätzlich soll über die Aufprallgeschwindigkeit bestimmt werden, wie schwerwiegend die Kollision war. Tritt keine Kollision auf, ist der minimale Abstand zwischen dem Einscherer und dem Egofahrzeug (Ego) mit dem Abstandsregeltempomat von Interesse. Zu diesen Vorgaben kann ein KPI-Plug-In mit spezifischen Wertebereichen definiert werden. Die konkrete Realisierung des KPI-Plug-Ins findet in einem KPI-Skript statt. Zu dem Skript wird eine Konfigurationsbeschreibung angelegt, in der die Bewertung beschreiben und die benötigten Simulationsinformationen aufgeführt werden. Dieser KPI-Plug-In kann als online oder als offline KPI-Plug-In realisiert werden. Bei der Testdefinition bekommt der KPI-Plug-In Mechanismus das KPI-Plug-In, bestehend aus dem Skript und der Konfigurationsbeschreibung. Während und / oder nach der Simulation wird das definierte KPI-Skript ausgeführt und der resultierende KPI-Wert wird abgespeichert. Nach der Testausführung des Autobahnszenarios kann das Egofahrzeug (Ego) auch in einem zweiten Szenario z.B. in der Innenstadt getestet werden. In diesem Fall liegen die für den KPI-Plug-In benötigten Simulationsinformation vor, sodass bei der Testdefinition erneut dieses KPI-Plug-In ausgewählt werden kann. Diese Wiederverwendbarkeit ist mit der Verwendung des KPI-Plug-In Mechanismus gegeben. Neben dem beschriebenen KPI-Plug-In zur Testung eines Abstandsregeltempomat, können weitere KPI-Plug-Ins verwendet werden, die z.B. den Komfort oder den Verbrauch des Fahrzeugs während der Testfahrt und / oder Simulation bewerten.

Figur 2 zeigt eine Funktion, die eine Grenze zwischen kritischen und nicht-kritischen Testergebnissen angibt. Die dargestellten Punkte sind simulierte Testergebnisse. Alternativ können es auch approximierte Testergebnisse sein.

Bei der dargestellten Funktion handelt es sich um die Sicherheits-Zielfunktion, welche in einer bevorzugten Ausführungsform einen numerischen Wert aufweist, der bei einem Sicherheitsabstand zwischen dem Egofahrzeug (Ego) und dem weiteren Kraftfahrzeug, dem Fellowfahrzeug, von ≥ VFELLOW x 0,55 einen Minimalwert aufweist, bei einer Kollision zwischen dem Egofahrzeug (Ego) und dem weiteren Kraftfahrzeug einen Maximalwert aufweist, und bei einem Sicherheitsabstand zwischen dem Kraftfahrzeug und dem weiteren Kraftfahrzeug von ≤ VFELLOW x 0,55 einen numerischen Wert aufweist, welcher größer als der Minimalwert ist. Eine solche Sicherheits-Zielfunktion kann Teil eines KPI-Skripts sein und zur Bestimmung eines KPI-Werts herangezogen werden.

Alternativ zur Sicherheits-Zielfunktion kann beispielsweise eine Komfort-Zielfunktion oder eine Effizienz-Zielfunktion simuliert und / oder approximiert werden, welche einen numerischen Wert aufweist, der im Falle keiner Änderung der Beschleunigung des Kraftfahrzeugs einen Minimalwert aufweist, bei einer Kollision zwischen dem Egofahrzeug (Ego) und dem weiteren Kraftfahrzeug einen Maximalwert aufweist, und bei einer Änderung der Beschleunigung des Egofahrzeug (Ego) in Abhängigkeit des Betrags der Änderung der Beschleunigung einen numerischen Wert zwischen dem Minimalwert und dem Maximalwert aufweist. Die Mehrzahl von Fahrsituationsparametern, insbesondere die Geschwindigkeit VEGO des Egofahrzeugs (Ego) und die Geschwindigkeit VFELLOW des weiteren Kraftfahrzeugs, des Fellowfahrzeugs, werden innerhalb des vorgegebenen Definitionsbereichs z.B. durch eine Simulation erzeugt.

Zur Bewertung können solche Zielfunktionen in einem KPI-Plug-In integriert und in der Test- und / oder Simulationsdefinition gewählt werden. Das KPI-Plug-In kann in der Simulation direkt ausgeführt werden, so dass ein KPI-Wert bestimmt werden kann.

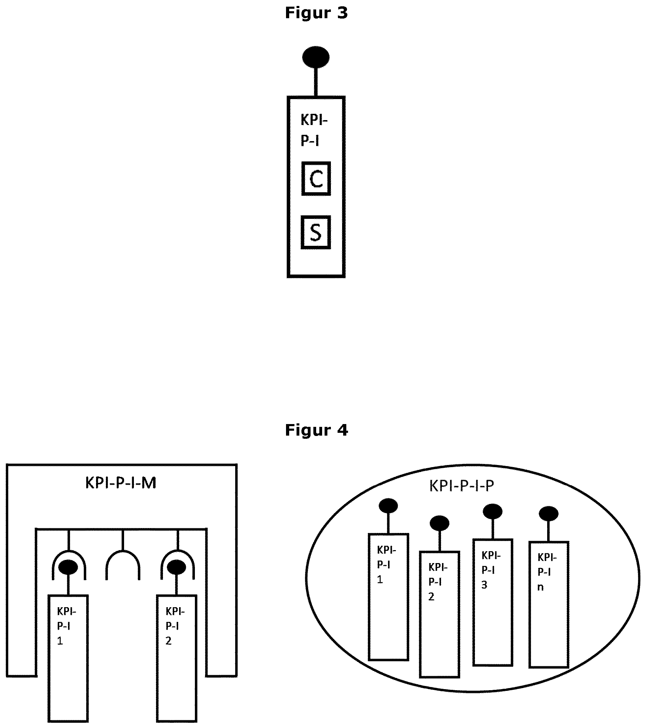

Figur 3 zeigt eine erfindungsgemäße Darstellung eines KPI-Plug-Ins (KPI-P-I). KPI-Plug-Ins (KPI-P-I) haben eine Schnittstelle zum KPI-Plug-In-Mechanismus. Darüber hinaus besteht ein KPI-Plug-In (KPI-P-I) aus einer Konfigurationsdatei (C) und einem ausführbaren Skript (S).

Die Konfigurationsdatei (C) gibt Information zur Verwendungsweise, also in welcher Art von Szenarien eine Bewertung ermöglicht wird an. Die Informationen können z.B. Szenerie-Parameter und / oder Fahrsituationsparameter beinhalten, wie insbesondere die Fahrbahnbreite im Szenario und / oder die Anzahl von Verkehrsteilnehmern und / oder Geschwindigkeitsrestriktionen. Diese Aufzählung ist nicht abschließend, sie dient lediglich zur Verdeutlichung der Art der Informationen. Zusätzlich wird durch die Konfigurationsdatei (C) festgelegt, ob das KPI-Plug-In (KPI-P-I) online, also während der Simulation oder offline, nach der Simulation verwendet werden kann.

Das ausführbare Skript (S) beinhaltet die Informationen zur Bestimmung eines KPI-Werts, der zur Bewertung der Simulation und / oder eines Simulationsschritts dient.

Figur 4 zeigt eine schematische Darstellung zur erfindungsgemäßen Beschreibung des KPI-Plug-In-Mechanismus (KPI-P-I-M) und des KPI-Plug-In Pools (KPI-P-I-P).

Im KPI-Plug-In Pool (KPI-P-I-P) werden alle zur Verfügung stehenden KPI-Plug-Ins (KPI-P-I) gesammelt und verwaltet. Dies betrifft aktuell verwendete KPI-Plug-Ins (KPI-P-I) wie auch nicht verwendete KPI-Plug-Ins (KPI-P-I). Es kann über den KPI-Plug-In Pool (KPI-P-I-P) alle bekannten KPI-Plug-Ins (KPI-P-I) eingesehen werden.

Der KPI-Plug-In-Mechanismus (KPI-P-I-M) steuert die automatische Ausführung der gewählten KPI-Plug-Ins (KPI-P-I). Im Gegensatz zu den gängigen Methoden, eine Bewertung in das Szenario-basierte-Testen zu integrieren und damit z.B. an das Szenario selbst zu knüpfen, managet der KPI-Plug-In-Mechanismus (KPI-P-I-M) die KPI-Plug-Ins (KPI-P-I) und deren Ausführung. Dadurch sind die KPIs nicht fest mit der Simulation verknüpft und müssen nicht pro Szenario oder SUT neu definiert werden, sondern werden als KPI-Plug-Ins (KPI-P-I) geführt, im KPI-Plug-In-Pool (KPI-P-I-P) verwaltet und durch den KPI-Plug-In-Mechanismus (KPI-P-I-M) ausgeführt. Dadurch kann eine Wiederverwendbarkeit der KPI-Plug-Ins (KPI-P-I) gewährleistet werden und die automatische Ausführung der KPI-Plug-Ins (KPI-P-I) stellt eine erhebliche Einsparung an Zeit und Ressourcen dar. Zur Laufzeit ladet, prüft und führt der KPI-Plug-In Mechanismus (KPI-P-I-M) die ausgewählten KPI-Plug-Ins automatisiert aus.

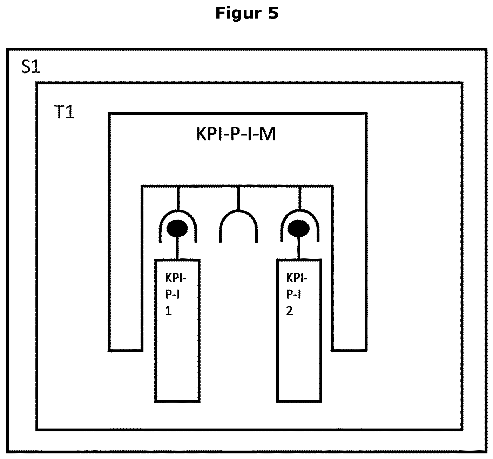

Figur 5 zeigt eine schematische Darstellung zur erfindungsgemäßen Beschreibung der Verwendung von KPI-Plug-Ins (KPI-P-I) in einem konkreten Szenario und damit in einer definierten Simulation / einem definierten Test.

Dazu wird in Figur 5 der KPI-Plug-In-Mechanismus (KPI-P-I-M) mit zwei KPI-Plug-Ins (KPI-P-I) KPI-P-I1 und KPI-P-I2 dargestellt. Der KPI-Plug-In-Mechanismus (KPI-P-I-M) ist in Verbindung mit einem Test T1 in einem Szenario S1 gezeigt.

Dabei sind die KPI-Plug-Ins (KPI-P-I) KPI-P-I1 und KPI-P-I2 nicht direkt mit dem Szenario verknüpft. Durch ihre generische und dynamische Definition können KPI-Plug-Ins (KPI-P-I) für verschiedene Szenarien und Tests wiederverwendet werden. Es wird demnach nicht für jedes neue Szenario ein neuer KPI-Plug-In-Mechanismus (KPI-P-I-M) bzw. kein neues KPI-Plug-In (KPI-P-I) erstellt.

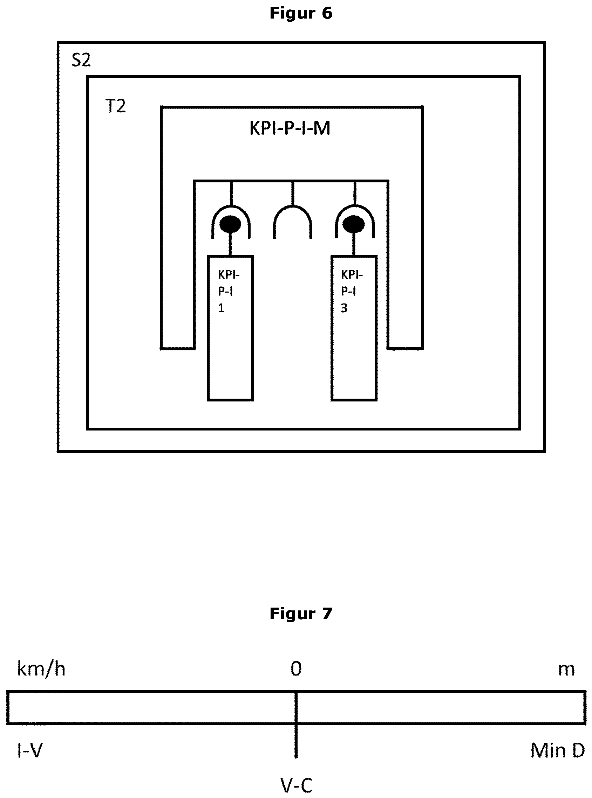

Auch Figur 6 zeigt eine schematische Darstellung zur erfindungsgemäßen Beschreibung der Verwendung von KPI-Plug-Ins (KPI-P-I) in einem konkreten Szenario und damit in einer definierten Simulation / Test.

Hier ist der KPI-Plug-In-Mechanismus (KPI-P-I-M) in Verbindung mit einem Test T2 in einem Szenario S2 dargestellt. In Figur 6 ist der KPI-Plug-In-Mechanismus (KPI-P-I-M) mit den KPI-Plug-Ins (KPI-P-I) KPI-P-I1 und KPI-P-I3 gezeigt. Die KPI-Plug-Ins (KPI-P-I) sind nicht direkt mit dem Szenario oder dem Test verknüpft. Es sei hierdurch verdeutlich, dass der KPI-Plug-In (KPI-P-I) KPI-P-I1 sowohl in S1, wie durch Figur 5 gezeigt, und in S2, wie in Figur 6 gezeigt, verwendet werden kann. Diese Wiederverwendung erfolgt ohne Anpassung des entsprechenden KPI-Plug-Ins und des dazugehörigen Skripts des KPI-Plug-Ins.

Figur 7 zeigt eine schematische Darstellung zur erfindungsgemäßen Bestimmung eines KPI-Werts. Wenn für ein Szenario und darin für ein bestimmtes SUT das Auftreten einer Kollision (V-C) relevant ist, ist hierzu ein KPI-Plug-In (KPI-P-I) zu wählen, wie eines, dass die Sicherheit der Fahrsituation bewertet (Safety KPI). Das KPI-Plug-In (KPI-P-I) kann insbesondere eine Aufprallgeschwindigkeit (I-V) bei einer Kollision (V-C) bestimmen oder sollte keine Kollision (V-C) auftreten einen minimalen Abstand (Min D) des Egofahrzeugs (Ego) und eines Fellowfahrzeugs angeben. Insbesondere in einem Cut-In-Szenario, in dem z.B. ein Abstandsregeltempomat getestet werden soll, sind diese Ergebnisse zur Bewertung des Szenarios relevant. Die ermittelten KPI-Werte können als Grundlage für eine erneute Parametrierung der Simulation verwendet werden.

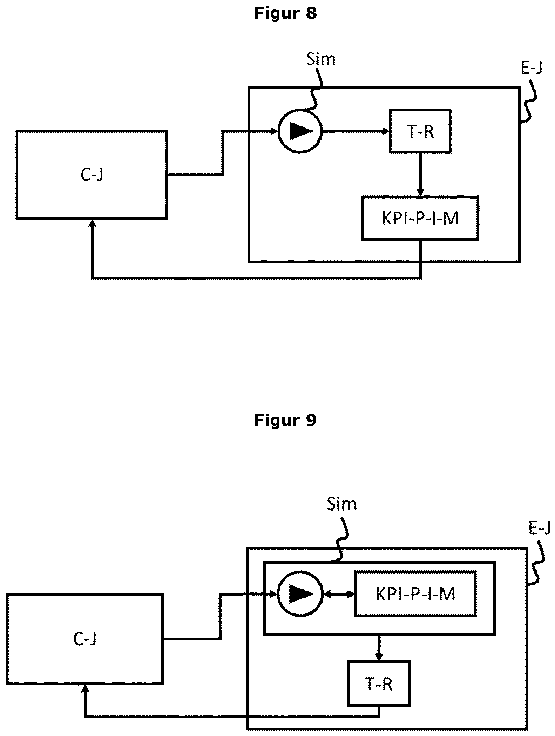

Figur 8 zeigt den Ablauf des erfindungsgemäßen offline-Einsatzes des KPI-Plug-In-Mechanismus (KPI-P-I-M).

Die KPIs in Form von KPI-Plug-Ins (KPI-P-I) können online oder offline durch den KPI-Plug-In-Mechanismus (KPI-P-I-M) ausgeführt werden. Im offline Fall kann die KPI-Ausführung, also die Ausführung von KPI-Plug-Ins (KPI-P-I) durch den KPI-Plug-In-Mechanismus (KPI-P-I-M) direkt nach der Simulation durchgeführt werden. Eine KPI-Ausführung zu einem späteren Zeitpunkt ist ebenfalls möglich.

Es werden zunächst eine Konfiguration (C-J) von Jobs bzw. Testfällen vorgenommen. Diese Konfiguration wird in der Testdurchführung (E-J) genutzt und dient als Eingabe für die Simulation (Sim). Durch die Simulation (Sim) werden Testergebnisse (T-R) erzeugt, die dem KPI-Plug-In-Mechanismus (KPI-P-I-M) zur Verfügung gestellt und bei der Ausführung der gewählten KPI-Plug-Ins (KPI-P-I) verwendet werden.

Ergebnisse des KPI-Plug-In-Mechanismus (KPI-P-I-M) in Form von KPI-Werten können in einer günstigen Ausführungsform wieder der Testkonfiguration (C-J) übergeben werden und zu einer optimierten Testerstellung führen. Eine Möglichkeit besteht darin, den KPI-Wert zur besseren Parameterkonfiguration zu verwenden, so dass eine erhöhte Testabdeckung erzielt werden kann.

Figur 9 zeigt den Ablauf des erfindungsgemäßen online-Einsatz des KPI-Plug-In-Mechanismus (KPI-P-I-M).

Dazu werden Informationen aus der Simulation (Sim) in einer bevorzugten Ausführungsform nach jedem Simulationsschritt an den KPI-Plug-In-Mechanismus (KPI-P-I-M) übergeben. Durch den KPI-Plug-In-Mechanismus (KPI-P-I-M) werden die gewählten KPI-Plug-Ins (KPI-P-I) ausgeführt und der KPI-Wert direkt wieder an die Simulation (Sim) übergeben. Ergebnisse (T-R) inklusive eines KPI-Werts werden zusammen an die Testerstellung und Konfiguration (C-J) übermittelt und können bevorzugt zur Erzeugung von optimierten Testfällen und / oder einer optimierten Parameterkonfiguration dienen.

Der KPI-Plug-In (KPI-P-I) kann zusätzlich als Abbruchbedingung für die Simulation (Sim) verwendet werden. Sollte in einer weiteren bevorzugten Ausführungsform ein durch den KPI-Plug-In-Mechanismus (KPI-P-I-M) erzeugten KPI-Wert einen in der Konfiguration definierten Schwellwert überschreiten, kann durch die Übermittlung des KPI-Werts im nächsten Simulationsschritt ein Abbruch der Simulation bedingt werden. Der Schwellwert kann in der Testdefinition enthalten sein und / oder in der Konfigurationsdatei (C) des KPI-Plug-In (KPI-P-I).

## Patentansprüche

1. Computerimplementiertes Verfahren zur Bewertung von Simulationen und / oder Testfällen im Szenario-basierten Testen und / oder Homologation von zu testenden zumindest teilweise autonomen Fahrfunktionen durch Key Performance Indicators (KPI), umfassend die Schritte:
Abbilden von KPIs durch KPI-Plug-ins;
dynamisches und wiederverwendbares Wählen von KPI-Plug-Ins für Simulationen und / oder Testfälle;
Wählen zumindest eines KPI-Plug-Ins durch einen KPI-Plug-In-Mechanismus bei der Simulations- und / oder Testdefinition;
automatisches Ausführen des gewählten KPI-Plug-Ins durch den KPI-Plug-In-Mechanismus während der Ausführung des KPI-Plug-In-Mechanismus;
Bestimmen eines KPI-Wertes durch Übergabe eines Simulationsergebnisses an ein KPI-Skript des KPI-Plug-Ins;
Übermitteln des Simulationsergebnisses und des KPI-Werts an eine Testerstellung und Konfiguration und Erzeugen optimierter Testfälle und / oder einer optimierten Parameterkonfiguration; und
Bereitstellen einer unter Verwendung der optimierten Testfälle und / oder der optimierten Parameterkonfiguration optimierten zumindest teilweise autonomen Fahrfunktion.

2. Computerimplementiertes Verfahren nach Anspruch 1, **dadurch gekennzeichnet, dass** zumindest ein Szenario zumindest einen Test einer Vorrichtung zur zumindest teilweisen autonomen Führung eines Verkehrsmittels und / oder Verkehrsteilnehmer umfasst.

3. Computerimplementiertes Verfahren nach Anspruch 2, **dadurch gekennzeichnet, dass** zumindest ein Test durch zumindest einen Parameter bestimmt wird, der zur Simulationslaufzeit und / oder zum Simulationsende abgefragt wird, wobei Parameter insbesondere beinhalten:
- Szenerie-Parameter umfassend zumindest eines der Merkmale: die Anzahl von und / oder die Breite eines Fahrstreifens und / oder Kurven und / oder Straßenbeschränkungen und / oder der Umgebungstemperatur,
- Fahrsituationsparameter, die die Anzahl und Eigenschaften beweglicher Objekte im Szenario beschreiben, umfassend zumindest eines der Merkmale:
die Anzahl von Verkehrsteilnehmer und / oder die Anzahl von Spurwechsel in einer Verkehrssituation und / oder die Geschwindigkeit der Verkehrsteilnehmer und / oder Verkehrsmittel.

4. Computerimplementiertes Verfahren nach Anspruch 2, **dadurch gekennzeichnet, dass** Verkehrsmittel und / oder Verkehrsteilnehmer zumindest Ego-Fahrzeuge und / oder Fellow-Fahrzeuge umfasst, wobei ein Ego-Fahrzeug das Fahrzeug mit dem zu testenden System (SUT) ist und ein Fellow-Fahrzeug ein beliebig weiteres Fahrzeug im Szenario ist.

5. Computerimplementiertes Verfahren nach Anspruch 1, **dadurch gekennzeichnet, dass** ein KPI-Plug-In aus einer Konfigurationsbeschreibung und einem durch einen Computer ausführbares Skript besteht.

6. Computerimplementiertes Verfahren nach einem der vorhergehenden Ansprüche, **dadurch gekennzeichnet, dass** online KPI-Plug-Ins zur Simulationslaufzeit und / oder offline nach der Simulation ausgeführt werden können.

7. Computerimplementiertes Verfahren nach Anspruch 6, **dadurch gekennzeichnet, dass** für online ausgeführte KPI-Plug-Ins, das ausführbare Skript automatisch zur Simulationslaufzeit gestartet wird und in jedem Simulationsschritt eine Bewertung von zumindest einem Parameter stattfindet, so dass die Bewertung auf zur Laufzeit zur Verfügung stehenden Simulationsparametern beruht und daraus ein KPI-Wert bestimmt wird.

8. Computerimplementiertes Verfahren nach Anspruch 6, **dadurch gekennzeichnet, dass** für offline ausgeführte KPI-Plug-Ins das ausführbare Skript automatisch nach Simulationsende gestartet wird, so dass der KPI-Wert auf Basis der Simulationsergebnisse bestimmt wird.

9. Computerimplementiertes Verfahren nach einem der vorhergehenden Ansprüche, **dadurch gekennzeichnet, dass** der aktuell bestimmte KPI-Wert eine Bewertung der aktuellen Simulation und / oder zumindest eines Simulationsschritts angibt.

10. Computerimplementiertes Verfahren nach einem der vorhergehenden Ansprüche, **dadurch gekennzeichnet, dass** der KPI-Plug-In-Mechanismus zumindest ein KPI-Plug-In beinhaltet und alle im KPI-Plug-In-Mechanismus ausgewählten KPI-Plug-In zur Simulations- und / oder Testausführung automatisch ausgeführt werden.

11. Computerimplementiertes Verfahren nach einem der vorhergehenden Ansprüche, **dadurch gekennzeichnet, dass** KPI-Plug-Ins in einem KPI-Plug-In-Pool verwaltet werden.

12. Testeinheit zur Bewertung von Simulationen und / oder Testfällen im Szenario-basierten Testen und / oder Homologation von zu testenden zumindest teilweise autonomen Fahrfunktionen durch Key Performance Indicators (KPI), umfassend:
Mittel zum Abbilden von KPIs durch KPI-Plug-ins;
dynamisches und wiederverwendbares Wählen von KPI-Plug-Ins für Simulationen und / oder Testfälle;
Mittel zum Wählen zumindest eines KPI-Plug-Ins durch einen KPI-Plug-In-Mechanismus bei der Simulations- und / oder Testdefinition;
Mittel zum automatischen Ausführen des gewählten KPI-Plug-Ins durch den KPI-Plug-In-Mechanismus während der Ausführung des KPI-Plug-In-Mechanismus;
Mittel zum Bestimmen eines KPI-Wertes durch Übergabe eines Simulationsergebnisses an ein KPI-Skript des KPI-Plug-Ins;
Mittel zum Übermitteln des Simulationsergebnisses und des KPI-Werts an eine Testerstellung und Konfiguration und Erzeugen optimierter Testfälle und / oder einer optimierten Parameterkonfiguration; und
Mittel zum Bereitstellen einer unter Verwendung der optimierten Testfälle und / oder der optimierten Parameterkonfiguration optimierten zumindest teilweise autonomen Fahrfunktion.

13. Testeinheit nach Anspruch 12, **dadurch gekennzeichnet, dass** die Testeinheit durch ein Steuergerät ausgebildet ist, für welches zumindest ein Szenario für virtuelle und / oder reale Tests bestimmt wird.

14. Computerprogramm mit Programmcode, um das Verfahren nach einem der Ansprüche 1 bis 11 durchzuführen, wenn das Computerprogramm auf einem Computer ausgeführt wird.

15. Computerlesbarer Datenträger mit Programmcode eines Computerprogramms, um das Verfahren nach einem der Ansprüche 1 bis 11 durchzuführen, wenn das Computerprogramm auf einem Computer ausgeführt wird.

## Claims

1. A computer-implemented method for evaluating simulations and/or test cases in scenario-based testing and/or homologation of at least partially autonomous driving functions to be tested by means of key performance indicators (KPI), comprising the steps:
mapping KPIs using KPI plug-ins;
dynamically and reusably selecting KPI plug-ins for simulations and/or test cases;
selecting at least one KPI plug-in by a KPI plug-in mechanism in the simulation and/or test definition;
automatically executing the selected KPI plug-in by the KPI plug-in mechanism during the execution of the KPI plug-in mechanism;
determining a KPI value by passing a simulation result to a KPI script of the KPI plug-in;
transmitting the simulation result and the KPI value to a test creation and configuration and generating optimized test cases and/or an optimized parameter configuration; and
providing an at least partially autonomous driving function optimized using the optimized test cases and/or the optimized parameter configuration.

2. The computer-implemented method according to claim 1, **characterized in that** at least one scenario comprises at least one test of a device for at least partially autonomously guiding a means of transport and/or road user.

3. The computer-implemented method according to claim 2, **characterized in that** at least one test is determined by at least one parameter interrogated at simulation runtime and/or at the end of the simulation, wherein parameters include in particular:
- scenery parameters comprising at least one of the features: the number of and/or the width of a lane and/or curves and/or road restrictions and/or the ambient temperature,
- driving situation parameters describing the number and properties of moving objects in the scenario, comprising at least one of the features:
the number of road users and/or the number of lane changes in a traffic situation and/or the speed of the road users and/or means of transport.

4. The computer-implemented method according to claim 2, **characterized in that** means of transport and/or road users comprise at least ego vehicles and/or fellow vehicles, wherein an ego vehicle is the vehicle having the system under test (SUT) and a fellow vehicle is any other vehicle in the scenario.

5. The computer-implemented method according to claim 1, **characterized in that** a KPI plug-in consists of a configuration description and a script executable by a computer.

6. The computer-implemented method according to any one of the preceding claims, **characterized in that** online KPI plug-ins can be executed at simulation runtime and/or offline after the simulation.

7. The computer-implemented method according to claim 6, **characterized in that** for KPI plug-ins executed online, the executable script is started automatically at simulation runtime and an evaluation of at least one parameter takes place in each simulation step, so that the evaluation is based on simulation parameters available at runtime and a KPI value is determined therefrom.

8. The computer-implemented method according to claim 6, **characterized in that** for KPI plug-ins executed offline, the executable script is started automatically after the end of the simulation, so that the KPI value is determined on the basis of the simulation results.

9. The computer-implemented method according to any one of the preceding claims, **characterized in that** the currently determined KPI value indicates an evaluation of the current simulation and/or of at least one simulation step.

10. The computer-implemented method according to any one of the preceding claims, **characterized in that** the KPI plug-in mechanism includes at least one KPI plug-in and all KPI plug-ins selected in the KPI plug-in mechanism for simulation and/or test execution are automatically executed.

11. The computer-implemented method according to any one of the preceding claims, **characterized in that** KPI plug-ins are managed in a KPI plug-in pool.

12. A test unit for evaluating simulations and/or test cases in scenario-based testing and/or homologation of at least partially autonomous driving functions to be tested by key performance indicators (KPI), comprising:
means for mapping KPIs using KPI plug-ins;
dynamically and reusably selecting KPI plug-ins for simulations and/or test cases;
means for selecting at least one KPI plug-in by a KPI plug-in mechanism in the simulation and/or test definition;
means for automatically executing the selected KPI plug-in by the KPI plug-in mechanism during the execution of the KPI plug-in mechanism;
means for determining a KPI value by passing a simulation result to a KPI script of the KPI plug-in;
means for transmitting the simulation result and the KPI value to a test creation and configuration and generating optimized test cases and/or an optimized parameter configuration; and
means for providing an at least partially autonomous driving function optimized using the optimized test cases and/or the optimized parameter configuration.

13. The test unit according to claim 12, **characterized in that** the test unit is implemented by a control device for which at least one scenario for virtual and/or real tests is determined.

14. A computer program having program code for performing the method according to any one of the claims 1 through 11 when the computer program is executed on a computer.

15. A computer-readable data storage medium having program code of a computer program for performing the method according to any one of the claims 1 through 11 when the computer program is executed on a computer.

## Revendications

1. Procédé mis en œuvre par ordinateur pour l'évaluation de simulations et/ou de cas tests dans l'exécution de tests et/ou l'homologation basées sur des scénarios de fonctions de conduite à tester, au moins partiellement autonomes, par des Indicateurs clés de performance (KPI), comprenant les étapes suivantes:
représentation d'Indicateurs clés de performance (KPI) par des extensions KPI;
sélection dynamique et réutilisable d'extensions KPI pour des simulations et/ou des cas tests;
sélection d'au moins une extension KPI par un mécanisme d'extension KPI lors de la définition de la simulation et/ou du test;
exécution automatique de l'extension KPI sélectionnée par le mécanisme d'extension KPI pendant l'exécution du mécanisme d'extension KPI;
détermination d'une valeur de KPI par transfert d'un résultat de simulation à un script de KPI de l'extension KPI;
transmission du résultat de simulation et de la valeur de KPI à une création de test et configuration et génération de cas tests optimisés et/ou d'une configuration de paramètres optimisée; et
mise à disposition d'une fonction de conduite au moins partiellement autonome, optimisée par utilisation des cas tests optimisés et/ou de la configuration de paramètres optimisée.

2. Procédé mis en œuvre par ordinateur selon la revendication 1, **caractérisé en ce qu'**au moins un scénario comprend au moins un test d'un dispositif destiné au guidage au moins partiellement autonome d'un moyen de transport et/ou d'usagers de la route.

3. Procédé mis en œuvre par ordinateur selon la revendication 2, **caractérisé en ce qu'**au moins un test est déterminé par au moins un paramètre qui est interrogé pendant la durée de la simulation et/ou à la fin de la simulation, les paramètres comprenant en particulier:
- des paramètres environnementaux comprenant au moins l'une des caractéristiques suivantes: le nombre de voies de circulation et/ou la largeur d'une voie de circulation et/ou des virages et/ou des restrictions routières et/ou la température ambiante,
- des paramètres de situation de conduite qui décrivent le nombre et les propriétés d'objets mobiles dans le scénario, comprenant au moins l'une des caractéristiques suivantes:
le nombre d'usagers de la route et/ou le nombre de changements de voie dans une situation de trafic et/ou la vitesse des usagers de la route et/ou des moyens de transport.

4. Procédé mis en œuvre par ordinateur selon la revendication 2, **caractérisé en ce que** les moyens de transport et/ou les usagers de la route comprennent au moins des véhicules autonomes et connectés et/ou des véhicules compagnons, un véhicule autonome et connecté étant le véhicule comprenant le système à tester (SUT) et un véhicule compagnon étant un véhicule supplémentaire quelconque dans le scénario.

5. Procédé mis en œuvre par ordinateur selon la revendication 1, **caractérisé en ce qu'**une extension KPI se compose d'une description de configuration et d'un script exécutable par un ordinateur.

6. Procédé mis en œuvre par ordinateur selon l'une des revendications précédentes, **caractérisé en ce que** des extensions KPI peuvent être exécutées en ligne pendant la durée de la simulation et/ou hors ligne après la simulation.

7. Procédé mis en œuvre par ordinateur selon la revendication 6, **caractérisé en ce que**, pour des extensions KPI exécutées en ligne, le script exécutable est lancé automatiquement pendant la durée d'exécution de la simulation et une évaluation d'au moins un paramètre a lieu à chaque étape de simulation, de sorte que l'évaluation est basée sur des paramètres de simulation disponibles pendant la durée d'exécution et qu'une valeur de KPI est déterminée à partir de ceux-ci.

8. Procédé mis en œuvre par ordinateur selon la revendication 6, **caractérisé en ce que**, pour des extensions KPI exécutées hors ligne, le script exécutable est lancé automatiquement après la fin de la simulation, de sorte que la valeur de KPI est déterminée sur la base des résultats de simulation.

9. Procédé mis en œuvre par ordinateur selon l'une des revendications précédentes, **caractérisé en ce que** la valeur de KPI actuellement déterminée indique une évaluation de la simulation actuelle et/ou d'au moins une étape de simulation.

10. Procédé mis en œuvre par ordinateur selon l'une des revendications précédentes, **caractérisé en ce que** le mécanisme d'extension KPI comprend au moins une extension KPI et toutes les extensions KPI sélectionnées dans le mécanisme d'extension KPI sont exécutées automatiquement pour l'exécution de la simulation et/ou des tests.

11. Procédé mis en œuvre par ordinateur selon l'une des revendications précédentes, **caractérisé en ce que** les extensions KPI sont gérées dans un groupe d'extensions KPI.

12. Unité de test pour l'évaluation de simulations et/ou de cas tests dans l'exécution de tests et/ou l'homologation basées sur des scénarios de fonctions de conduite à tester, au moins partiellement autonomes, par des Indicateurs clés de performance (KPI), comprenant:
des moyens pour représenter des KPI par des extensions KPI;
sélection dynamique et réutilisable d'extensions KPI pour des simulations et/ou des cas tests;
des moyens pour sélectionner au moins une extension KPI par un mécanisme d'extension KPI lors de la définition de la simulation et/ou du test;
des moyens pour exécuter automatiquement l'extension KPI sélectionnée par le mécanisme d'extension KPI pendant l'exécution du mécanisme d'extension KPI;
des moyens pour déterminer une valeur de KPI par transfert d'un résultat de simulation à un script de KPI de l'extension KPI;
des moyens pour transmettre le résultat de simulation et la valeur de KPI à une création de test et configuration et génération de cas tests optimisés et/ou d'une configuration de paramètres optimisée; et
des moyens pour mettre à disposition une fonction de conduite au moins partiellement autonome, optimisée par utilisation des cas tests optimisés et/ou de la configuration de paramètres optimisée.

13. Unité de test selon la revendication 12, **caractérisée en ce que** l'unité de test est formée par un appareil de commande pour lequel est déterminé au moins un scénario pour des tests virtuels et/ou des tests réels.

14. Programme informatique comprenant un code de programme pour mettre en œuvre le procédé selon l'une des revendications 1 à 11 lorsque le programme informatique est exécuté sur un ordinateur.

15. Support de données lisible par ordinateur avec code de programme d'un programme informatique, pour mettre en œuvre le procédé selon l'une des revendications 1 à 11 lorsque le programme informatique est exécuté sur un ordinateur.
